# EUROPEAN PATENT APPLICATION

(11) **EP 4 831 661 A1**
(43) Date of publication of application: **28.10.2026**
(21) Application number: 24908363.5
(22) Date of filing: 18.12.2024
(51) Int. Cl.: G01R 31/367, G01R 31/396, G01R 31/382, G06N 20/00, H01M 10/48

(54) **MACHINE LEARNING-BASED BATTERY CHARGE/DISCHARGE CURRENT PREDICTION METHOD AND DEVICE FOR CHARGE/DISCHARGE STRATEGY FOR BATTERY THERMAL MANAGEMENT**

(30) Priority: 20.12.2023 KR 20230187567
(71) Applicant: SAMSUNG SDI CO., LTD., Yongin-si, Gyeonggi-do 17084 (KR); Korea Advanced Institute of Science and Technology, Daejeon 34141 (KR)
(72) Inventor: KOO, Yong Rack, Yongin-Si Gyeonggi-do 17084 (KR); SEO, Jun Yong, Daejeon 34141 (KR); LEE, Bong Jae, Daejeon 34141 (KR); HAN, Ji Hye, Daejeon 34141 (KR); RYU, Mi Ran, Yongin-Si Gyeonggi-do 17084 (KR); YOON, Seok Joon, Yongin-Si Gyeonggi-do 17084 (KR)
(74) Representative: Gulde & Partner
(86) International application number: PCT/KR2024/097146
(87) International publication number: WO 2025/136059

(57) **Abstract**

Provided is a method of predicting battery charge/discharge current executed by a computing device, including obtaining training data and verification data including temperature profiles according to battery charge/discharge current profiles, training a machine learning model by using the training data, verifying the trained machine learning model by using the verification data and retraining the machine learning model, and predicting a current profile according to a battery temperature profile by using the machine learning model.

## Description

### Technical Field

The present disclosure relates to a method and a device for predicting battery charge/discharge current based on machine learning of charge and discharge strategy for battery thermal management.

### Background Art

Secondary batteries are batteries which may be charged and discharged, unlike primary batteries which are not chargeable. Secondary batteries with less capacity are used for portable small-sized electronic apparatuses, such as smartphones, feature phones, laptop computers, digital cameras, camcorders, and secondary batteries with larger capacity are widely used as motor-driving power sources and power-saving batteries of hybrid vehicles, electric vehicles, and the like. A secondary battery includes an electrode assembly including an anode and a cathode, a case accommodating the same, an electrode terminal connected to the electrode assembly, and the like.

Research has been widely conducted on a forward prediction technique, for example, predicting a state of charge (SoC) of a battery by using parameters such as a current, a voltage, or a temperature of a battery including the secondary battery, however, regarding battery charge and discharge strategies, research on a backward prediction technique about a next operation strategy based on a current battery temperature is insufficient.

The aforementioned information disclosed in the background art is only to improve understanding about the background of the present disclosure, and thus may also include information that does not construct the related art.

### Disclosure of Invention

### Technical Problem

The technical goal to be achieved by the present disclosure is to provide a method and a device for predicting a battery charge/discharge current based on machine learning of a charge/discharge strategy for battery thermal management.

However, technical goals to be achieved by the present disclosure are not limited thereto, and other unmentioned technical goals may be clearly understood by those of skill in the art from the descriptions described hereinafter.

### Solution to Problem

To achieve the technical goals, a method of predicting a battery charge and discharge current performed by a computing device, according to an embodiment of the present disclosure, includes obtaining training data and verification data, wherein the training data includes a temperature profile according to a battery charge and discharge current profile, training a machine learning model by using the training data, verifying and retraining the trained machine learning model by using the verification data, and predicting a current profile according to a battery temperature profile by using the machine learning model.

According to an example, the predicting of the current profile according to the battery temperature profile may include predicting a change in a battery charge and discharge current according to time which satisfies a change in battery temperature according to time.

According to another example, the obtaining of the training data and the verification data may include obtaining pieces of data about the change in the battery charge and discharge current according to time and the change in the battery temperature according to the change in the battery charge and discharge current.

According to another example, the obtaining of the training data and the verification data may include obtaining pieces of data through random sampling to extract a combination of variables having a uniform distribution within a combination and a range of given variables.

According to another example, the obtaining of the training data and the verification data may include obtaining the training data and the verification data both having a same distribution but respectively including different types of current data and temperature data.

According to another example, the training of the machine learning model may include training the machine learning model configured to receive the battery temperature T(t) according to time, a first-order rate of change of the battery temperature △T(t), a second-order rate of change of the battery temperature △²T(t), and the battery charge state SoC(t) according to time as input values and outputting the current of the battery according to time as an output value.

According to another embodiment, the first-order rate of change △T(t) of the battery temperature and a second-order rate of change △²T(t) of the battery temperature may have a correlation below with the battery temperature T(t) according to time.

The first-order rate of change: $Δ T \left(t\right) = \left(0\left(t=0\right)\right) and \left(T\left(t\right)-T\left(t-1\right)\left(t≻0\right)\right)$

The second-order rate of change: ${Δ}^{2} T \left(t\right) = \left(0\left(t\leq 1\right)\right) and \left(T\left(t\right)+T\left(t-2\right)-2T\left(t-1\right)\left(t≻1\right)\right)$

According to another embodiment, the battery charge state SoC(t) according to time may be expressed as the following equation, based on the battery current *I'*(*t*) predicted according to time. $SoC \left(t\right) = SoC \left(t-1\right) + Γ \left(t-1\right) \times Δ t \left(t\geq 1\right)$

According to another embodiment, the verifying and retraining of the machine learning model may include predicting a prediction value for the battery current based on the battery temperature through the machine learning model by using the verification data not included in the learning data, comparing the prediction value for the current with current data of the verification data, and comparing battery temperature data, which is obtained from the prediction value for the current, with battery temperature data of the verification data.

As a technical solution to achieve the aforementioned technical goals, a computer program stored in a recording medium is provided to execute the aforementioned method by using a computing device.

To achieve the aforementioned technical goals, an apparatus for predicting a battery charge and discharge current according to an embodiment of the present disclosure is provided, the apparatus including a memory configured to store training data and verification data, wherein the training data includes a temperature profile according to a battery charge and discharge current profile, and a processor configured to obtain the training data and the verification data, train a machine learning model by using the training data, verify and retrain the trained machine learning model by using the verification data, and predict a current profile according to a battery temperature profile by using the machine learning model.

According to an example, the processor may be configured to predict a change in the battery charge and discharge current according to time, which satisfies a change in a battery temperature according to time.

According to another example, the processor may be configured to obtain pieces of data regarding a change in a battery charge and discharge current according to time and a change in a battery temperature according to the change in the battery charge and discharge current.

According to another example, the processor may be configured to train the machine learning model configured to receive the battery temperature T(t) according to time, a first-order rate of change of the battery temperature △T(t), a second-order rate of change of the battery temperature △²T(t), and the battery charge state SoC(t) according to time as input values and output the current of the battery according to time as an output value.

According to another example, the processor may be configured to, by using the verification data not included in the training data, predict a prediction value for a battery current based on a battery temperature through the machine learning model, compare the prediction value for the current with current data of the verification data, and compare battery temperature data, which is obtained from the prediction value for the current, with battery temperature data of the verification data.

### Advantageous Effects of Invention

According to the present disclosure, a machine learning-based backward prediction model configured to predict a charge/discharge profile satisfying a given battery temperature profile may be secured, and in this process, training efficiency may also be promoted by sequentially increasing an amount of training data.

However, effects that may be obtained through the present disclosure are not limited to the aforementioned effects, and other technical effects not mentioned will be clearly understood to those of skill in the art from mode for the invention.

### Brief Description of Drawings

The following diagrams attached to the present specification illustrate desirable embodiments of the present disclosure and facilitate understanding of the technical spirit of the present disclosure in conjunction with detailed descriptions to be described later, and therefore, the present disclosure shall not be construed as being limited to contents shown in the drawings.
FIG. 1 is a diagram schematically illustrating a battery pack according to an embodiment of the present disclosure.
FIG. 2 is a flowchart for describing a method of predicting a battery charge/discharge current according to an embodiment of the present disclosure.
FIG. 3 is a diagram for describing a charge state profile and a current profile corresponding to the charge state profile, according to an embodiment of the present disclosure.
FIGS. 4 and 5 are diagrams for describing a method of predicting a battery charge/discharge current according to an embodiment of the present disclosure.

### Mode for the Invention

Hereinafter, desirable embodiments of the present disclosure will be described in detail with reference to the accompanying drawings. Theretofore, the terms or words used in the present specifications and the claims are not to be interpreted as being limited to conventional or lexical senses, and are to be interpreted as senses and concepts according with the technical spirit of the present disclosure based on principles that the inventers may appropriately define concepts of the terms to describe his/her invention through an utmost method. Accordingly, embodiments disclosed in the present specification and configuration illustrated in the drawings are only some embodiments most desirable in the present disclosure and are not to fully represent the technical spirit of the present disclosure, and it will be understood that there may be various equivalents and modifications to substitute the same at the time of application. In addition, when used in the present specification, "comprise, include" and/or "comprising, including" are to specify existence of the mentioned shapes, numbers, stages, operations, members, elements, and/or groups thereof, and are not to exclude existence or addition of one or more other shapes, numbers, operations, members, elements, and/or groups. In addition, in the description of embodiments of the present disclosure, "may be ~" and "may indicate ~" may include "one or more embodiments of the present disclosure.

In addition, to facilitate understanding of the disclosure, the accompanying drawings may be not illustrated at a real scale, and sizes of some components may be illustrated with exaggeration. In addition, in different embodiments, same reference numerals may be given to same components.

Reference of 'equality' of two objects of comparison indicates 'being substantially equal'. Therefore, substantial equality may include a case of having a deviation considered as a low level in the art, for example, a deviation within 5 %. In addition, an expression that a certain parameter is uniform in a certain area may indicate being uniform in an average point of view.

Although terms such as first, second, and the like are used to describe various components, the components are not limited thereto. These terms are only used to distinguish one component from other components, and unless specifically indicated otherwise, a first component may be a second component.

Throughout the specification, unless specifically indicated otherwise, each component may be singular or plural.

An expression that an arbitrary composition is arranged on top (or bottom)" of a component or "above (or under)" the component may indicate that another composition may be arranged between the component and the arbitrary composition arranged above (or under) the component, as well as that the arbitrary composition is arranged adjacent to a top surface (or a bottom surface) of the component.

In addition, when a component is "coupled," "combined," or "connected" to another component, it will be understood that the components may be directly coupled or connected to each other, but another component may be arranged "between" components, or the components may be "coupled," "combined," or "connected" to each other through the other component. In addition, when a portion is electrically coupled to another portion, this also includes a case in which the portion is coupled to the other portion with another element therebetween, as well as a case of being directly coupled.

Throughout the specification, "A and/or B", unless specifically disclosed otherwise, indicates A, B, or A and B. That is, "and/or" includes all or any combinations of a plurality of listed items. "C to D", unless specifically disclosed otherwise, indicates C or greater and D or less.

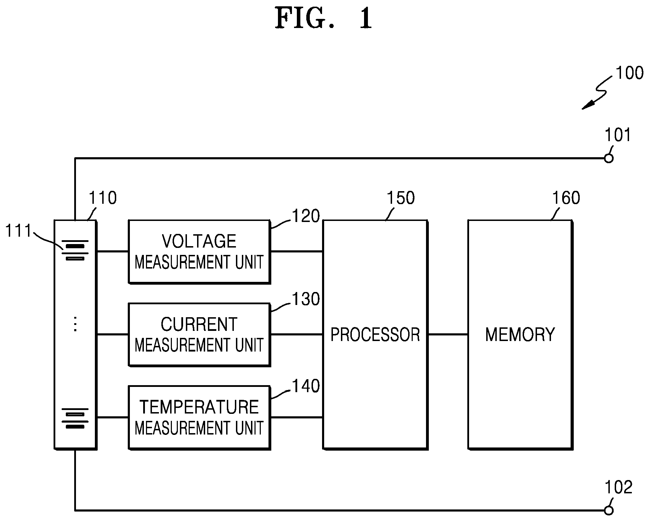

FIG. 1 schematically illustrates a battery pack according to an embodiment of the present disclosure.

Referring to FIG. 1, a battery pack 100 includes a battery module 110, a processor 150, a memory 160, a voltage measurement unit 120, a current measurement unit 130, and a temperature measurement unit 140.

The battery pack 100 includes a pack housing, in which at least one battery module 110 and an accommodation space to accommodate the at least one battery module 110 is formed. The battery module 110 may include a plurality of battery cells 111 and a module housing. The battery cells 111 may be accommodated into the module housing in the form of a stack. The battery cell 111 may include an anode lid and a cathode lid. As the battery cell 111, battery cells of a circular type, a polygonal type, and a pouch type may be used according to the form of the battery.

In the battery pack 100, instead of the battery module, a cell stack formed by stacking may constitute a module. The cell stack may be accommodated into the accommodation space of the pack housing or an accommodation space divided by frames, partitions, and the like.

The battery cell 111 generates a great amount of heat during charge/discharge. The generated heat is accumulated in the battery cell 111 and hastens degradation of the battery cell 111. Accordingly, the battery pack 100 further includes a cooling member to inhibit the degradation of the battery cell. The cooling member is provided at a bottom of the accommodation space in which the battery cell 111 is provided, but is not limited thereto, and may also be provided at a top or side surfaces depending on the battery pack 100.

In the battery cell 111, an exhaust gas in the battery cell, which is generated under abnormal operation conditions respectively known as a thermal runway or a thermal event, may be discharged to the outside of the battery cell. The battery pack 100 or the battery module 110 may be provided with an exhaust port and the like to inhibit damage to the battery or the module due to the exhaust gas.

The battery module 110 may include at least one battery cell 111, and the battery cell 111 may be a rechargeable secondary battery. For example, the battery cell 111 may include at least one selected from among a group consisting of a nickel-cadmium battery, a lead storage battery, a nickel metal hybrid (NiMH) battery, a lithium-ion battery, a lithium polymer battery, and the like.

The number and coupling type of the battery cell 111 included in the battery module 110 may be determined based on an amount of electric power and a voltage required for the battery pack 100. Although FIG. 1 illustrates that the battery cells 111 included in the battery module 110 are connected in series, only for a conceptual purpose, the battery cells 111 may be connected in parallel to each other, and may also be connected in series or in parallel. Although FIG. 1 illustrates that the battery pack 100 includes a single battery module 110, only for a conceptual purpose, may also include a plurality of battery modules 110 connected in series, in parallel, or in series and in parallel. The battery module 110 may also include only one battery cell 111.

The battery module 110 may include a plurality of battery modules each constituted with the plurality of battery cells 111. The battery pack 100 includes a pair of pack terminals 101 and 102 to which an electric load or a charge device may be coupled.

The battery pack 100 according to an embodiment of the present disclosure may include a switch. The switch may be coupled between the battery module 110 and one of the pack terminals 101 and 102. The switch may be controlled by the processor 150. Although not shown in FIG. 1, the battery pack 100 may further include a battery protection circuit, a fuse, a current sensor, and the like.

A device for predicting a battery charge/discharge current according to an embodiment of the disclosure includes the processor 150 and the memory 160.

The processor 150 is configured to control general operations of the device for predicting the battery charge/discharge current. For example, to perform the aforementioned operations, the processor 150 may be implemented in the form selectively including a processor known in the field, Application-Specific Integrated Circuit (ASIC), other chipsets, logic circuits, registers, communication modems, and/or data processing devices.

The processor 150 may be configured to perform fundamental calculation, logic, and input/output operations, and for example, may execute program codes stored in the memory 160. The processor 150 may be configured to store data in the memory 160 or load the data stored in the memory 160.

The memory 160, which is a recording medium that may be read by the processor 150, may include permanent mass storage devices such as random access memory (RAM), read-only memory (ROM), and disk drives. An operating system and at least one program or application code may be stored in the memory 160. A program code for predicting a current profile according to a battery temperature profile by using a machine learning model, according to an embodiment of the present disclosure, may be stored in the memory 160. For example, training data and verification data including thermal profiles according to battery charge/discharge current profiles may be stored in the memory 160. For example, data generated by measuring at least one parameter of the battery module 110 may be stored in the memory 160. In addition, a nominal capacity of the battery module 110 may be stored in the memory 160. In addition, state of charge (SOC)-open circuit voltage (OCV) data of the battery module 110 may be stored in the memory 160. For example, the data may include a charge/discharge current, a terminal voltage, and a temperature of the battery. In addition, the data may include a discharge rate of the battery. A program code for estimating an SOC of the battery by using data generated by measuring at least one parameter of the battery module 110 and the SOC-OCV data may be stored in the memory 160. The at least one parameter of the battery module 110 indicates components or variables such as a terminal voltage, a charge/discharge current, and/or an ambient temperature of the battery module 110.

The device for predicting the battery charge/discharge current according to an embodiment of the present disclosure may further include the voltage measurement unit 120, the current measurement unit 130, and the temperature measurement unit 140 configured to measure the at least one parameter of the battery module 110. The device for predicting the battery charge/discharge current according to an embodiment of the present disclosure may further include a communication module configured to communicate with other devices such as an electronic control device for a vehicle, a controller for a charge device, and the like.

The voltage measurement unit 120 may be configured to measure a voltage of the battery module 110. For example, as shown in the configuration in FIG. 1, the voltage measurement unit 120 may be electrically coupled to two ends of the battery module 110 and/or the battery cell 111. In addition, the voltage measurement unit 120 may be electrically coupled to the processor 150, so as to exchange electric signals. In addition, the voltage measurement unit 120 may be configured to, under control of the processor 150, measure voltages at two ends of the battery module 110 and/or the battery cell 111 with a time interval and output, to the processor 150, signals indicating magnitudes of the measured voltages. Here, the processor 150 may determine the voltage of the battery module 110 and/or the battery cell 111 based on the signals output from the voltage measurement unit 120. For example, the voltage measurement unit 120 may be implemented by using a voltage measurement circuit generally used in the art.

In addition, the current measurement unit 130 may be configured to measure the current of the battery. For example, as illustrated in the configuration in FIG. 1, the current measurement unit 130 may be electrically coupled to a current sensor provided on a charge/discharge path of the battery module 110 and/or the battery cell 111. In addition, the current measurement unit 130 may be electrically coupled to the processor 150, so as to exchange electric signals. In addition, the current measurement unit 130 may be configured to, under control of the processor 150, repeatedly measure a magnitude of a charge current or a discharge current of the battery module 110 and/or the battery cell 111 and output, to the processor 150, a signal indicating the magnitude of the measured current. Here, the processor 150 may determine magnitude of the current based on the signal output from the current measurement unit 130. For example, the current sensor may be implemented by using a hall sensor or a sense resistance generally used in the art.

The temperature measurement unit 140 may be configured to measure a battery temperature. For example, as illustrated in the configuration in FIG. 1, the temperature measurement unit 140 may be coupled to the battery module 110 and/or the battery cell 111 and measure a temperature of the secondary battery provided in the battery module 110 and/or the battery cell 111. In addition, the temperature measurement unit 140 may be electrically coupled to the processor 150, so as to exchange electric signals. In addition, the temperature measurement unit 140 may be configured to repeatedly measure a temperature of the secondary battery with a time interval and output, to the processor 150, a signal indicating a value of the measured temperature. Here, the processor 150 may determine the temperature of the secondary battery based on the signal output from the temperature measurement unit 140. For example, the temperature measurement unit 140 may be implemented by using a thermocouple generally used in the art.

In addition, the processor 150 may also be configured to monitor and calculate a state of battery module (a voltage, a current, a temperature, an SOC, a state of heath (SOH), and the like) by using at least one of a voltage measurement value, a current measurement value, and a temperature measurement value of the battery module 110 received from the voltage measurement unit 120 120, the current measurement unit 130, and the temperature measurement unit 140. Here, the SOC may be obtained as a numerical value corresponding to a residual charge amount of the battery module 110. In addition, the processor 150 may also be configured to control functions (e.g., temperature control, balancing control, charge and discharge control, and the like), protection functions (e.g., functions of preventing over-discharge, overcharge, and overcurrent, short circuit, extinction, and the like), based on a result of the monitoring of the state. Furthermore, the processor 150 may also be configured to perform wired or wireless communication functions with an external device (e.g., a supervisory controller, a vehicle, a charger, or a personal communication service (PCS)).

The processor 150 may also be configured to control charge/discharge operations and protection operation of the battery. To do so, the processor 150 may include a charge/discharge controller, a balancing controller, and a protector.

A battery management system including the processor 150, which is a system configured to monitor the state of the battery and perform diagnosis, control, communication, and protection functions, may be configured to calculate a charge/discharge state, calculate the SOH of the battery, block (relay control) battery power when needed, control thermal management (cooling, heating, and the like), perform a high-voltage interlock function, and detect or calculate states of insulation and short circuit.

In an aspect of the present disclosure, the processor 150 may be configured to estimate the SOC of the battery module 110 by integrating the charge/discharge current of the battery module 110. Here, when charge or discharge of the battery module 110 starts, an initial value of a charge state may be determined by using an OCV of the battery module 110 measured before the charge or discharge starts. To do so, the processor 150 may map a charge state corresponding to the OCV of the battery module 110 from SOC-OCV data, based on the SOC-OCV data which defines the charge state according to each OCV. <Equation 1> $SoC = {SoC}_{i - 1} + dSoC$ where SOC indicates the charge state of the battery, SoCᵢ₋₁ indicates the initial value in the charge state of the battery, and dSOC indicates a value obtained by integration of the charge/discharge current of the battery.

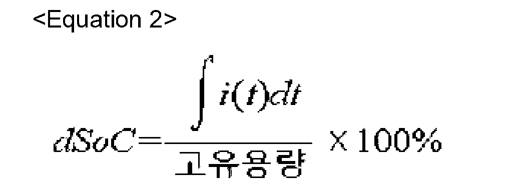

Here, dSOC indicates a value obtained by integrating the value obtained by integration of the charge/discharge current of the battery from a time point at which the charge or discharge starts, and the nominal capacity indicates a design capacity of the battery.

In another aspect of the present disclosure, the processor 150 may be configured to estimate the SOC of the battery module 110 by using Extended Kalman filter. The Extended Kalman filter indicates a mathematical algorithm for adaptively estimating a charge state of the secondary battery by using a voltage, a current, and a temperature of the secondary battery.

In addition to a current integration method or the Extended Kalman filter described above, the SOC of the battery module 110 may also be determined through other well-known methods by which the charge state may be estimated by selectively using the voltage, the current, and the temperature of the secondary voltage.

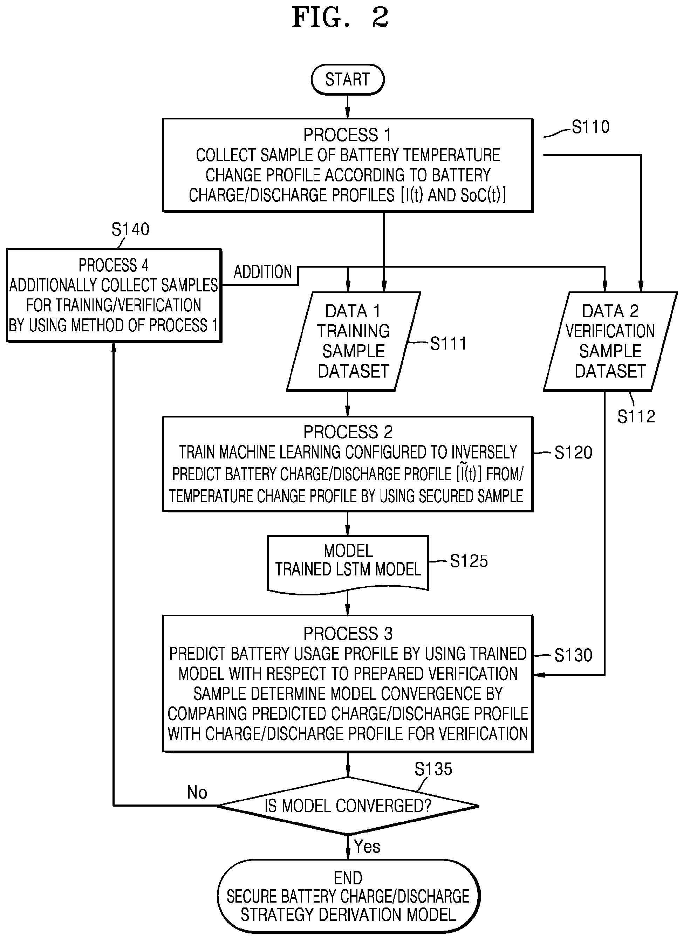

FIG. 2 is a flowchart for describing a method of predicting a battery charge/discharge current according to an embodiment of the present disclosure. The method of predicting the battery charge/discharge current according to an embodiment of the present disclosure may be performed by the processor 150 illustrated in FIG. 1.

Referring to FIG. 2, the method of predicting the battery charge/discharge current according to the present disclosure includes obtaining training data and verification data including temperature profiles according to charge/discharge current profiles of the battery (S110), training a machine learning model by using the training data (S120), verifying the trained machine learning model by using the verification data and retraining the machine learning model (S130), and predicting a current profile according to a battery temperature profile by using the machine learning model (S140).

According to an embodiment, the obtaining of the training data and the verification data (S110) may include obtaining pieces of data about a change in the battery charge/discharge current over time and a change in the battery temperature according to the change in the battery charge/discharge current.

In addition, according to an embodiment, the obtaining of the training data and the verification data (S110) may include obtaining pieces of data through random sampling to extract a combination of variables having a uniform distribution within a combination and a range of given variables.

In addition, according to an embodiment, the obtaining of the training data and the verification data (S110) may include obtaining the training data (S111) and the verification data (S112) both having a same distribution but respectively including different types of current data and thermal data.

The processor 150 according to an embodiment of the present disclosure may be configured to obtain a temperature profile T(t) according to various types of battery charge/discharge profiles I(t). Here, t is a time index and may indicate information regarding time points according to certain intervals. For example, in embodiments of the present disclosure, a profile having a 50-second interval and a total amount of 3600 seconds (t = 0, 1, ...., 72) may be used.

For example, a method of obtaining the training data (S111) and the verification data (S112) according to an embodiment of the present disclosure may be used for securing the pieces of data to be used for both of training and verifying of the machine learning model. Here, although a battery temperature for an arbitrary current profile may be secured through various methods, characteristics of the machine learning model requires a great number of samples, and therefore, in the present disclosure, data may be collected by using COMSOL simulation. However, the present disclosure is not limited thereto, and the present disclosure does not limit particular methods to obtain the temperature profile T(t) according to the current profile I(t).

Regardless of methods of acquiring the training data, a method of constructing a machine learning-based model suggested in the present disclosure is expected to operate when a consistent correlation exists between an input (a temperature and the like) and an output (a current and the like) used for training. However, to satisfy the number of pieces of training data required in a machine learning methodology generally performed, it is beneficial to apply a method of securing numerical data through a thermal fluid analysis.

In embodiments of the present disclosure, a battery operation was imitated by using COMSOL, i.e., a commercial thermal fluid analysis program, and verification was performed with respect to current-temperature data secured through the imitation. This COMSOL battery model is a calculation model verified with experimental measurements. For example, the battery temperature verified through an experiment is a temperature of an outer wall of the battery can, and the temperature in the embodiment of the present disclosure may indicate a temperature at a center of an internal structure of the battery.

In addition, as it is important to train the model for charge and discharge profiles within the utmost various ranges, the training data (S111) and the verification data (S112) may be obtained without inter-sample bias by using Latin-Hypercube sampling method. For example, generally, the number of pieces of verification data may be set as 1 to 5% of the number of pieces of training data.

For example, the current profile I(t) may be extracted by using the Latin-Hypercube sampling. For example, the Latin-Hypercube (LH) sampling may indicate a sampling method by which arbitrary combinations of numerical values and variables with minimal bias within a given range. For example, the processor 150 may set a shape of the current profile as a step-function shape, and extract variables imitating the step-function through the LH sampling method, so as to avoid bias within a current range.

In addition, based on that determination on a charge state profile SoC(t) changing over time is followed by determination on a current profile corresponding thereto, the processor 150 may extract four variables imitating the current state profile, i.e., an initial charge state SoC₀, a change point charge state SoC_{c}, a final point charge state SoC₁, and a change point t_{c} through the LH sampling, and convert these four variables into the current profile for use. For example, respective of the variables may have a range as in Equation 3. <Equation 3> $0 \leq {SoC}_{0} , {SoC}_{t} , {SoC}_{1} \leq 1$ 300 seconds≤t_{c}≤3300 seconds

Here, the change point t_{c} of a current step-function is set to be between 300 to 3300 seconds, so as to prevent a rapid change in the charge state, that is, an excessive increase in a magnitude of the current.

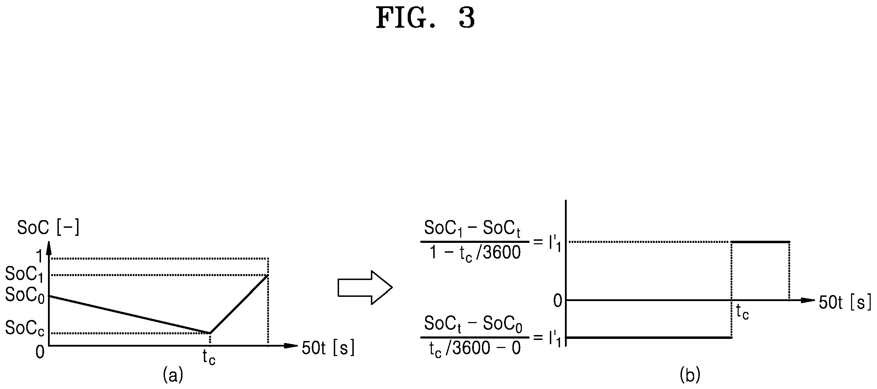

Referring to FIG. 3, FIG. 3 schematizes the charge state profile over time and the current profile corresponding thereto, and current profiles according to combinations of variables may be prepared according to corresponding interaction formulae. For example, the current may flow with a magnitude of I₀' from 0 to t_{c} seconds, and may flow with a magnitude of I1' from t_{c} to 3600 seconds.

According to an embodiment, the training of the machine learning model (S120) may include training the machine learning model configured to receive the battery temperature T(t) over time, a first-order rate of change △T(t) of the battery temperature, a second-order rate of change △²T(t) of the battery temperature, and the battery charge state SoC(t) over time as input values and outputting the battery current over time as an output value.

In addition, according to an embodiment, the first-order rate of change △T(t) of the battery temperature and the second-order rate of change △²T(t) of the battery temperature may have a correlation as in Equation 4 with the battery temperature T(t) over time. <Equation 4> $\begin{matrix}The first - order rate of change : \\ Δ T \left(t\right) = \left(0\left(t=0\right)\right) and \left(T\left(t\right)-T\left(t-1\right)\left(t≻0\right)\right) \\ The second - order rate of change : \\ {Δ}^{2} T \left(t\right) = \left(0\left(t\leq 1\right)\right) and \left(T\left(t\right)+T\left(t-2\right)-2T\left(t-1\right)\left(t≻1\right)\right)\end{matrix}$

In addition, according to an embodiment, the battery charge state SoC(t) over time may be expressed as in Equation 5, based on the battery current *I'*(*t*) predicted over time. <Equation 5> $SoC \left(t\right) = SoC \left(t-1\right) + Γ \left(t-1\right) \times Δ t \left(t\geq 1\right)$

The processor 150 according to an embodiment of the present disclosure may be configured to train an LTSM-based machine learning model based on the training data S111. For example, embodiments of the present disclosure may be performed by using Deep Learning Toolbox of MATLAB. In addition, the trained machine training model (S125) may be stored and used for verification processes thereafter.

For example, the machine training model may receive a charge amount SoC(t), the temperature T(t), a first-order rate of change T(t)-T(t-1) of the temperature, and a second-order rate of change T(t)+T(t-2)-2T(t-1) of the temperature as an input profile. For example, a two-dimensional rate of change of the temperature may include physical information for detecting a rapid current change which significantly influences the temperature. In addition, the charge amount SoC(t) may be obtained as an accumulated value of the current according to time.

The machine learning model (S125) according to an embodiment of the present disclosure may predict, as an output value, a current *I'*(*t*) profile by which the input charge amount and the temperature may be satisfied. For example, the predicted current profile may function as a charge/discharge strategy by which the given charge amount and temperature profile may be satisfied.

For example, in a state where the temperature profile T(t) and the initial charge state SoC(0) among variables used as the input values are known, the processor 150 may obtain a current profile for the temperature profile.

In addition, the processor 150 may be configured to secure the first-order rate of change and the second-order rate of change of the temperature in Equation 4 by using the secured temperature profile. For example, a charge state at a next time point may be updated based on a predicted current, as in Equation 6.

### <Equation 6>

Here, the reason of multiplying by 50/3600 is that a unit of the current is C-rate and thus is charged/discharged in an amount of 50 seconds of an hour.

The processor 150 may predict the current *I'*(*t*) of each time point according to the time index t. For example, the processor 150 may secure a final current profile *I'*(*t*) for every time index (t = 1, 2, ..., 72).

According to an embodiment, the verifying and retraining of the machine learning model (S130 and S140) may include predicting a prediction value for the battery current based on the battery temperature through the machine learning model by using the verification data not included in the training data, comparing the prediction value for the current with current data of the verification data, and comparing battery temperature data, which is obtained from the prediction value for the current, with battery temperature data of the verification data.

For example, the processor 150 may predict a charge/discharge profile *I'*(*t*) and verify authenticity thereof by using the verification data (S112). For example, a method of verifying may include 1) comparing a difference between a current profile I(t) causing the input profile used for prediction and the predicted current profile *I'*(*t*) or 2) re-obtaining a temperature profile T'(t) based on the predicted current profile, through the method of operation S110, and comparing the re-obtained temperature profile with an initial temperature profile.

For example, the processor 150 may obtain the verification data, i.e., a true value, through the method of operation S110. For example, the processor 150 may obtain the verification data including the current profile and the temperature profile.

For example, the processor 150 may predict the prediction value for the battery current based on the battery temperature through the machine-learning model by using the verification data not included in the training data. Next, the processor 150 may compare the prediction value for the current with the current data of the verification data.

In addition, the processor 150 may compare the battery temperature data, which is obtained from the prediction value for the current, with the battery temperature data of the verification data.

The processor 150 according to an embodiment of the present disclosure, when convergence of the machine learning model is secured by using the method of 1) or 2), may derive the charge/discharge strategy by using the machine learning model. Alternatively, when the convergence of the machine learning model is insufficient, the processor 150 according to an embodiment of the present disclosure may retrain the machine learning model. For example, the convergence of the machine learning model may be determined as converged when an error between pieces of compared data corresponds to a preset range.

For example, when the convergence of the machine learning model is not secured, the processor 150 may additionally obtain the training data and verification data. For example, the processor 150 may additionally obtain another piece of training data, and when needed, verification data, by using the same method as in the operation S110. For example, the verification data may be additionally obtained when the number of samples of the training data is identified to have decreased from a ratio (1~5%) previously maintained. Next, the processor 150 may perform again training and verification of the machine learning model by using enhanced training data and verification data.

According to an embodiment, the predicting of the current profile according to the battery temperature may include predicting a change in the battery charge/discharge current over time, which satisfies a change in the battery temperature over time.

For example, when the convergence of the machine learning model is secured in verification of the machine learning model, the processor 150 may finally store the trained machine learning model and use the trained machine learning model to derive the battery charge/discharge strategy thereafter. For example, the trained machine learning model may reversely predict and derive a current profile (i.e., the charge/discharge strategy) satisfying the given temperature profile.

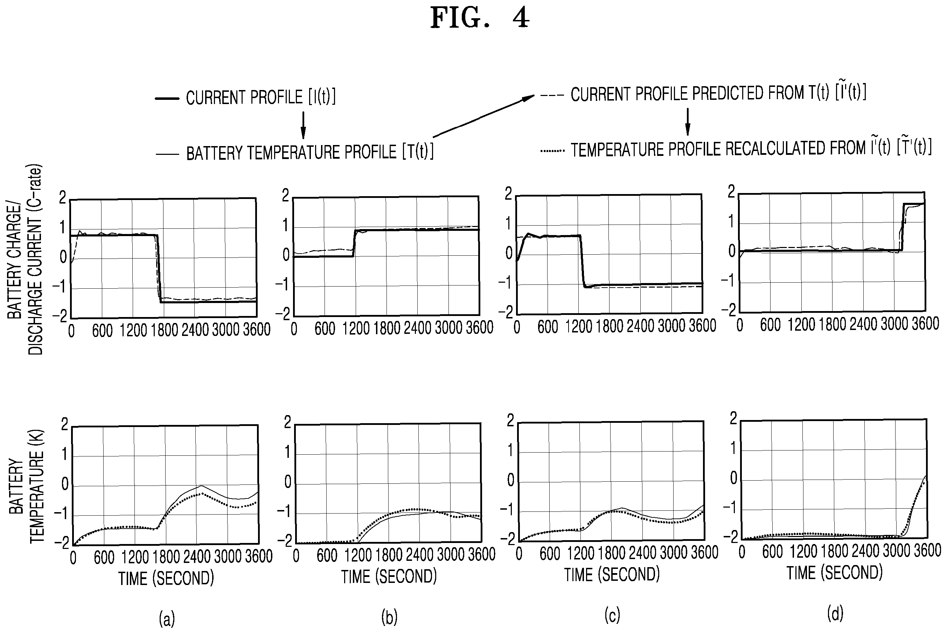

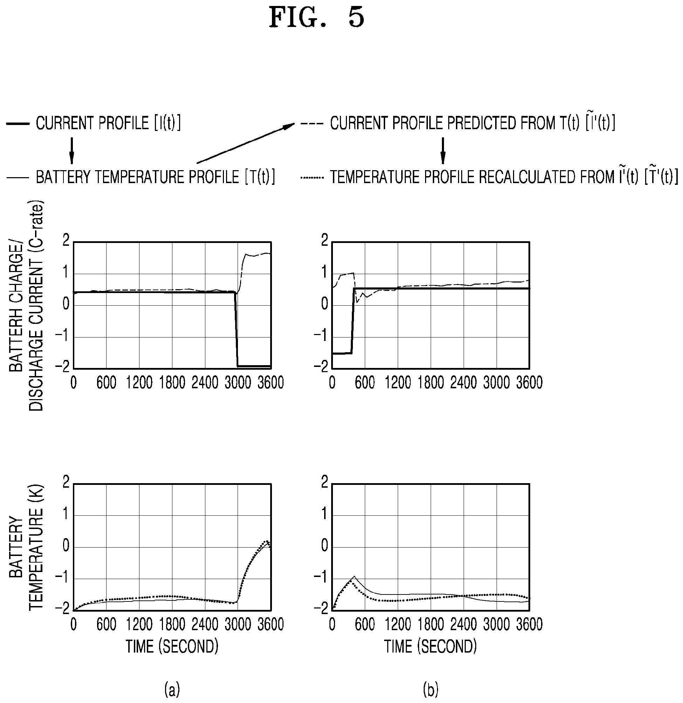

FIGS. 4 and 5 are diagrams for describing a method of predicting a battery charge/discharge current according to an embodiment of the present disclosure.

FIGS. 4 and 5 illustrate a battery current profile, a battery temperature profile, a current profile predicted based on the battery current profile, and a temperature profile recalculated based on the predicted current profile, according to an embodiment of the present disclosure. Here, the battery temperature profile may be derived from the current profile through the method of the operation S110. For example, total 4,397 pieces of training data and 77 pieces of verification data are used in the embodiments of the present disclosure.

For example, (a) to (d) of FIG. 4 illustrate examples of the verification data. The machine learning model may be verified by comparing the battery current profile with the current profile predicted based on the battery current profile. Alternatively, the machine learning model may be verified by comparing the battery temperature profile with the temperature profile recalculated from the predicted current profile. Here, a horizontal axis may indicate time (unit: second), and a vertical axis may indicate a current magnitude (unit: C-rate) for the current and an internal temperature of the battery (unit: K) for the temperature.

For example, (a) and (b) of FIG. 5 illustrate examples of verification data, in which charge/discharge strategies different from the true value are obtained through prediction by using the machine learning model but recalculated temperatures are different from the true value.

There may be a case in which the current profile *I'*(*t*) predicted through the method suggested in the present disclosure is different from the true value I(t). However, referring to FIG. 5, the temperature profile T'(t) re-obtained through the method of operation S110 may be equal to the true value T(t). Based thereon, the method suggested in the present disclosure presents the charge/discharge strategy from various aspects, as well as simple backward prediction on the charge/discharge strategy, so as to suggest an efficient battery usage method to users.

The present disclosure relates to a method of backward prediction on charge/discharge information from which an arbitrary temperature of the battery may be output, by training with the temperature data that may be obtained in a process of driving the battery.

Unlike the forward prediction to predict a current state (the charge amount and the like) based on battery output data, the present disclosure may derive, through backward prediction, the battery charge/discharge strategy that satisfies restriction (the temperature and the like) on arbitrary use of the battery.

Unlike forecast-like prediction of a future usage pattern based on actual usage patterns of users, the present disclosure may establish a strategy of driving the battery within a normal range to suggest, to the users, a real-time battery usage strategy according to current use.

Unlike the related art in which additional optimization procedures are needed for establishment of the battery usage strategy, the present disclosure may promptly predict the battery usage strategy through backward prediction on a learning model.

By using the present disclosure, a machine learning-based backward prediction model configured to predict a charge/discharge profile satisfying a given battery temperature profile may be secured, and in this process, training efficiency is also promoted by sequentially increasing the amount of training data.

According to embodiments of the present disclosure, the charge/discharge profile may be directly predicted based on the given battery temperature profile, and by doing so, the charge/discharge strategy required for real-time dynamic battery thermal management may be suggested promptly and accurately.

According to embodiments of the present disclosure, the secured prediction model may also suggest a substitute charge/discharge profile, as well as an initial charge/discharge profile which caused the battery temperature profile, to thereby contribute to establishment of various charge/discharge strategies.

Although the present disclosure has been described with reference to limited embodiments and drawings, the present disclosure is not limited thereto, and various modifications and transformations may be made within an equivalent range of the technical spirit of the present disclosure and the following claims by those of skill in the art.

Various embodiments described above may be implemented in the form of a computer program that may be executed through various components on computers, and such computer program may be recorded in a computer-readable medium. Here, the medium may continuously store or temporarily store the computer-executable programs for execution or download. In addition, the medium may include various types of recording units or storage units having the form of single hardware or a combination of a plurality of hardware, and may be distributed on the network without being limited to a medium directly accessing a certain computer system. An example of the medium may include a medium configured to store program instructions, including a magnetic medium such as hard disk, floppy disk, and a magnetic tape, an optical recording medium such as CD-ROM and DVD, a magneto-optical medium such as floptical disk, ROM, RAM, flash memory, and the like. In addition, another example of the medium may include a recording medium or a storage medium managed by an application store distributing applications, a site supplying and distributing other various software, a server, and the like.

In the present specification, "unit," "module," and the like may indicate a hardware component such as a processor or a circuit, and/or a software component executed by the hardware component such as the processor. For example, "units," "modules," and the like may be implemented by components such as software component, object-oriented software components, class components, and task components, processes, functions, features, procedures, subroutines, segments of program codes, drivers, firmware, microcodes, circuits, data, databases, data structures, tables, arrays, and variables.

## Claims

1. A method of predicting a battery charge/discharge current executed by a computing device, the method comprising:
obtaining training data and verification data comprising temperature profiles according to battery charge/discharge current profiles;
training a machine learning model by using the training data;
verifying and retraining the trained machine learning model by using the verification data; and
predicting a current profile according to a battery temperature profile by using the machine learning model.

2. The method of claim 1, wherein
the predicting of the current profile according to the battery temperature profile comprises predicting a change in a battery charge/discharge current over time, which satisfies a change in a battery temperature over time.

3. The method of claim 1, wherein
the obtaining of the training data and the verification data comprises obtaining pieces of data regarding a change in a battery charge/discharge current over time and a change in a battery temperature according to the change in the battery charge/discharge current.

4. The method of claim 3, wherein
the obtaining of the training data and the verification data comprises obtaining the pieces of data through random sampling to extract a combination of variables having a uniform distribution within a combination and a range of given variables.

5. The method of claim 4, wherein
the obtaining of the training data and the verification data comprises obtaining the training data and the verification data both having a same distribution but respectively comprising different types of current data and temperature data.

6. The method of claim 1, wherein
the training of the machine learning model comprises training the machine learning model configured to receive a battery temperature T(t) according to time, a first-order rate of change △T(t) of the battery temperature, a second-order rate of change △²T(t) of the battery temperature, and a battery charge state SoC(t) according to time as input values and output a battery current over time as an output value.

7. The method of claim 6, wherein
the first-order rate of change △T(t) of the battery temperature and the second-order rate of change △²T(t) of the temperature have a correlation as follows with the battery temperature T(t) according to time, where
The first-order rate of change: $Δ T \left(t\right) = \left(0\left(t=0\right)\right) and \left(T\left(t\right)-T\left(t-1\right)\left(t≻0\right)\right)$
The second-order rate of change: ${Δ}^{2} T \left(t\right) = \left(0\left(t\leq 1\right)\right) and \left(T\left(t\right)+T\left(t-2\right)-2T\left(t-1\right)\left(t≻1\right)\right) .$

8. The method of claim 6, wherein
the battery charge state SoC(t) over time is expressed as in Equation written below, based on the battery current *I'*(*t*) predicted over time: $SoC \left(t\right) = SoC \left(t-1\right) + Γ \left(t-1\right) \times Δ t \left(t\geq 1\right) .$

9. The method of claim 1, wherein
the verifying and retraining of the machine learning model comprises:
predicting a prediction value for a battery current based on a battery current through the machine learning model by using the verification data not included in the training data;
comparing the prediction value for the current with current data of the verification data; and
comparing battery temperature data obtained from the prediction value for the current and battery temperature data of the verification data.

10. A computer program stored in a recording medium to execute the method of any one of claims 1 to 9 by using a computing device.

11. A device for predicting battery charge/discharge current, the device comprising:
a memory configured to store training data and verification data, wherein the training data comprises a temperature profile according to a battery charge/discharge current profile; and
at least one processor configured to obtain the training data and the verification data, train a machine learning model by using the training data, verify the trained machine learning model by using the verification data and retrain the machine learning model, and predict a current profile according to a battery temperature profile by using the machine learning model.

12. The device of claim 11, wherein
the processor is configured to predict a change in a battery charge/discharge current over time, which satisfies a change in a battery temperature according to time.

13. The device of claim 11, wherein
the processor is configured to obtain pieces of data regarding a change in a battery charge/discharge current over time and a change in a battery temperature according to the change in the battery charge/discharge current.

14. The device of claim 11, wherein
the processor is configured to train the machine learning model configured to receive, as input values, a battery temperature T(t) according to time, a first-order rate of change △T(t) of a battery temperature, a second-order rate of change △²T(t) of the battery temperature, and a battery charge state SoC(t) over time, and output a battery current over time as an output value.

15. The apparatus of claim 11, wherein
the processor is configured to, by using the verification data not included in the training data, predict a prediction value for a battery current based on a battery temperature through the machine learning model, compare the prediction value for the current with current data of the verification data, and compare battery temperature data, which is obtained from the prediction value for the current, with battery temperature data of the verification data.
